(19) **Europäisches Patentamt**

**European Patent Office**

**Office européen des brevets**

(11) **EP 1 635 500 A1**

(12) **EUROPEAN PATENT APPLICATION**

(43) Date of publication:
**15.03.2006 Bulletin 2006/11**

(51) Int Cl.:
**H04L 1/06** (2006.01)

(21) Application number: **05254161.2**

(22) Date of filing: **01.07.2005**

| (84) | Designated Contracting States:<br>**AT BE BG CH CY CZ DE DK EE ES FI FR GB GR HU IE IS IT LI LT LU LV MC NL PL PT RO SE SI SK TR**<br>Designated Extension States:<br>**AL BA HR MK YU** | (72) | Inventors:<br>• **Skraparlis, Dimitrios, c/o Toshiba Res. Europe Ltd**<br>  **Bristol BS1 4ND (GB)**<br>• **Parker, Steve C. J., c/o Toshiba Res. Europe Ltd**<br>  **Bristol BS1 4ND (GB)** |
|---|---|---|---|
| (30) | Priority: **14.09.2004 GB 0420465** | (74) | Representative: **Round, Edward Mark**<br>**Marks & Clerk**<br>**90 Long Acre**<br>**London WC2E 9RA (GB)** |
| (71) | Applicant: **Kabushi Kaisha Toshiba**<br>**Tokyo 105-8001 (JP)** | | |

(54) **A receiver for use in MIMO system**

(57)    A receiver is provided which is operable to receive a multiple element signal resultant from a MIMO transmission. The receiver includes decoding means for identifying symbols, from a predetermined set of such symbols, carried in the signal. The decoding means is operable to estimate the corresponding bits according to a pre-defined mapping of symbols to bits along with associated likelihood information representing the likelihood of an identified bit being such a bit. The decoding means is operable in two functional stages.

A first decoding stage searches exhaustively across a set of possible symbols for the most likely candidate symbol, while a second stage takes account of an orthogonal transmission of information on two transmit antennas and decodes this information accordingly. The second stage is operable to detect remaining bits of data.

FIGURE 4

EP 1 635 500 A1

**Description**

This invention relates to a receiver for use in a Multiple Input, Multiple Output (MIMO) communications system, and is directed particularly, but not exclusively, at improvements in the manner of decoding a received signal into symbols of a possible set (constellation) of such symbols.

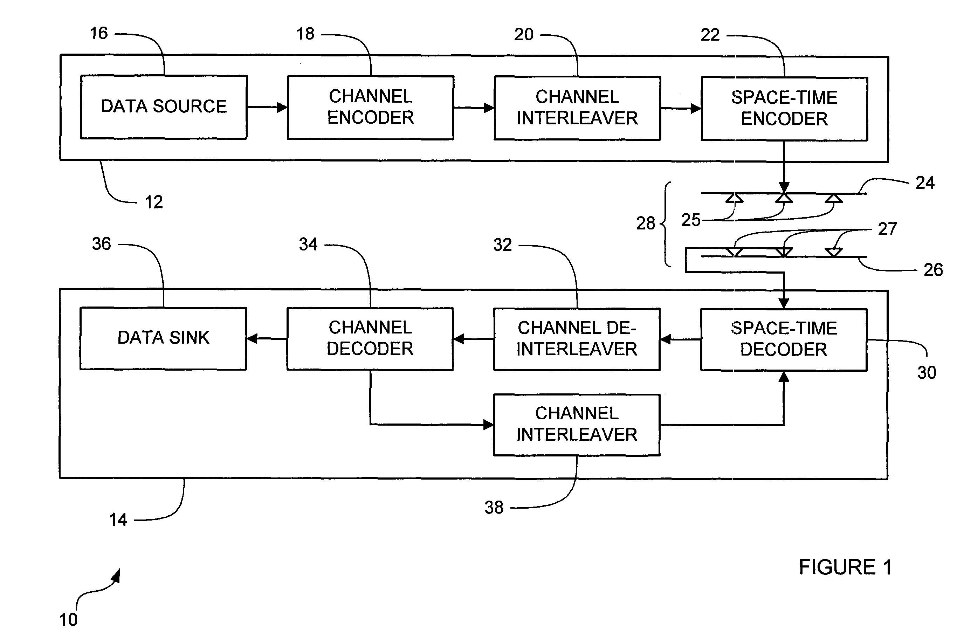

Figure 1 shows a MIMO data communications system 10 of known construction. The communications system 10 comprises a transmitter device 12 and a receiver device 14. It will be appreciated that in many circumstances, a wireless communications device will be provided with the facilities of a transmitter and a receiver in combination but, for this example, the devices have been illustrated as one way communications devices for reasons of simplicity.

The transmitter device 12 comprises a data source 16, which provides data (comprising information bits or symbols) to a channel encoder 18. The channel encoder 18 in this example comprises a convolutional coder such as a recursive systematic convolutional (RSC) encoder, or a stronger so-called turbo encoder (which includes an interleaver). More bits are output than are input, and typically the rate is one half or one third.

The channel encoder 18 is followed by a channel interleaver 20 and, in the illustrated example, a space-time encoder 22. The space-time encoder 22 encodes an incoming stream of bits as a plurality of code symbols for simultaneous transmission from a transmitter antenna array 24 comprising a plurality of transmit antennas 25. In this illustrated example, three transmit antennas 25 are provided.

The encoded transmitted signals propagate through a MIMO channel 28 defined between the transmit antenna array 24 and a corresponding receive antenna array 26 of the receiver device 14. The receive antenna array 26 comprises a plurality of receive antennas 27 which provide a plurality of inputs to a space-time (and/or frequency) decoder 30 of the receiver device 14. In this specific embodiment, the receive antenna array 26 comprises three receive antennas 27.

The decoder 30 has the task of removing the effect of the encoder 22. The output of the decoder 30 comprises a plurality of bits, equal to the number of the bits input to the space-time encoder 22, each carrying so-called soft or likelihood data on the probability of a each bit having a particular value, i.e. +1 or -1. This data is provided to a channel de-interleaver 32 which reverses the effect of the channel interleaver 20, and the convolutional code output by this channel de-interleaver 32 is then presented to a channel decoder 34, in this example a Viterbi decoder, which decodes the convolutional code.

Typically, the channel decoder 34 is a SISO (soft-in soft-out) decoder, that is operable to receive bit likelihood data and to provide similar likelihood data as an output rather than, say, data on which a hard decision has been made. The output of channel decoder 120 is provided to a data sink 36, for further processing of the data in any desired manner.

MIMO decoders attempt to solve the "integer least-squares problem", i.e. find $\tilde{s}$ that minimizes the distance $d_{min}$ between the received vector r and the operation of the MIMO channel matrix H on $\tilde{s}$. This problem can be expressed as a process of estimating s that produces $d_{min} = \min\|r - H\tilde{s}\|^2$, where $r = H\tilde{s} + n$ is the MIMO channel transfer equation.

The channel transfer matrix $H$ is assumed to be perfectly known by the receiver, but this assumption is not restrictive for the scope of this invention. The channel transfer matrix $H$ is normally estimated using pre-defined training sequences sent by the transmitter and specific techniques for channel estimation do not affect the design of the technology presented in this invention.

Traditional Maximum Likelihood (ML) detection requires an exhaustive evaluation of $2^{q \cdot N}$ distance metrics, where $q$ is the number of bits in the symbol constellation (e.g. 6 for 64-QAM, 4 for 16-QAM, 2 for QPSK) and $N$ is the number of layers (symbols) to be jointly decoded (e.g. N for spatial-multiplexing on N transmit antennas).

A soft-output decoder must also provide reliability information on the estimated bits, which are used by the channel decoder to improve the bit detection performance. The log-likelihood reliability/ratio for each bit $b_k$ is given by the natural logarithm of the ratio of the probability that this bit is 1 divided by the probability that this bit is -1 (possible bit states are regarded as +1 and -1).

$$L(b_k) = \ln \frac{\Pr(b_k = +1\|r)}{\Pr(b_k = -1\|r)}$$

It can be shown that the Max-Log approximation transforms this reliability formula into:

$$L(b_k) = \min_{s|b_k=-1} \frac{\|r - H\tilde{s}\|^2}{N_0} - \min_{s|b_k=+1} \frac{\|r - H\tilde{s}\|^2}{N_0} \qquad (1)$$

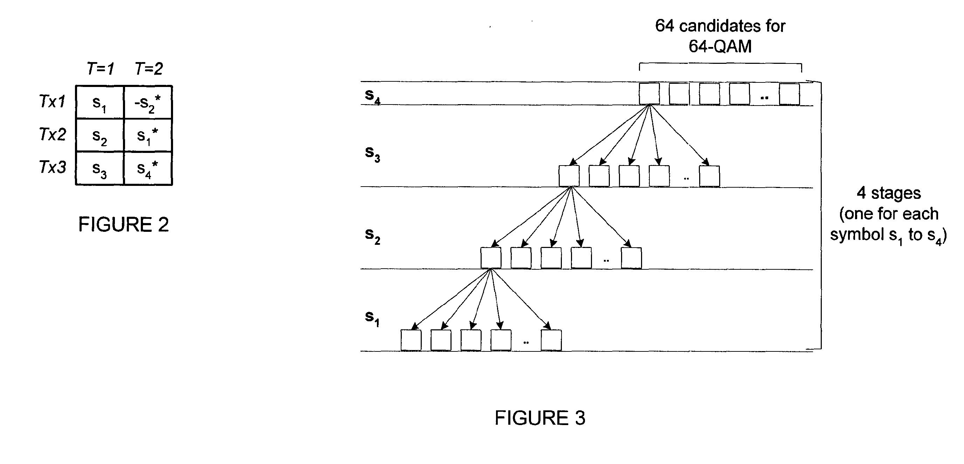

The reliability formula depends on both the distance metrics and the noise variance. A typical Space-Time code specifically designed for 3 transmit antennas is illustrated in the table set out in figure 2. The first two antennas are encoded with the "Alamouti" ST-code, but it is possible to use any ST-code or Space-Frequency code that provides orthogonality. For example, "Combined array processing and space-time coding" Tarokh, V.; Naguib, A.; Seshadri, N.; Calderbank, A.R., *Information Theory, IEEE* (*Transactions on,* Vol.45, Iss.4, May 1999, Pages:1121-1128), describes such an arrangement. In this document, antennas at the transmitter are partitioned into groups that use individual space-time codes. However, the suggested detector is not an ML-detector but an interference suppression method similar to BLAST.

The MIMO system for which solution of the integer squares problem is required, as well as providing reliability information according to equation 1, is:

$$\begin{bmatrix} r_{11} & r_{12} \\ r_{21} & r_{22} \\ r_{31} & r_{32} \end{bmatrix} = \begin{bmatrix} h_{11} & h_{12} & h_{13} \\ h_{21} & h_{22} & h_{23} \\ h_{31} & h_{32} & h_{33} \end{bmatrix} \begin{bmatrix} s_1 & -s_2{}^* \\ s_2 & s_1{}^* \\ s_3 & s_4{}^* \end{bmatrix} + \begin{bmatrix} n_{11} & n_{12} \\ n_{21} & n_{22} \\ n_{31} & n_{32} \end{bmatrix} \qquad (2)$$

It is assumed that the channel is quasi-static, i.e. the channel matrix does not change over two time intervals. A similar assumption (over frequency) has to be assumed in the case of Space-Frequency Alamouti encoding. In the general case of a Space-Time-Frequency code, the channel is assumed quasi-static over both dimensions (Time and Frequency).

Equation 2 can be restructured as:

$$\begin{bmatrix} r_{11} \\ r_{21} \\ r_{31} \\ r_{12}{}^* \\ r_{22}{}^* \\ r_{32}{}^* \end{bmatrix} = \begin{bmatrix} h_{11} & h_{12} & h_{13} & 0 \\ h_{21} & h_{22} & h_{23} & 0 \\ h_{31} & h_{32} & h_{33} & 0 \\ h_{12}{}^* & -h_{11}{}^* & 0 & h_{13}{}^* \\ h_{22}{}^* & -h_{21}{}^* & 0 & h_{23}{}^* \\ h_{32}{}^* & -h_{31}{}^* & 0 & h_{33}{}^* \end{bmatrix} \begin{bmatrix} s_1 \\ s_2 \\ s_3 \\ s_4 \end{bmatrix} + \begin{bmatrix} n_{11} \\ n_{21} \\ n_{31} \\ n_{12}{}^* \\ n_{22}{}^* \\ n_{32}{}^* \end{bmatrix} \qquad (3)$$

The submatrix *h* consisting of the first two columns of the channel matrix H represent the Alamouti orthogonalized channel, which has the property $h^H h = \gamma I$. This property is taken into consideration in the design of the reduced-complexity ML detectors as will be described in the following explanation of the specific embodiment of the invention.

The tree structure of a conventional soft-output MIMO ML-detector for the system of equation 3 is shown in figure 3. Figure 3 illustrates the ML-decoding tree for a specific ST-code which will be used throughout later description of specific embodiments of the invention, for the purpose of consistency.

The structure consists of 4 layers, each layer consisting of all $2^q$ possible candidates for each unique symbol in the Space-Time transmission scheme (figure 2). The ML detector searches exhaustively over all possible combinations of symbols $s_1$ to $s_4$; a distance metric $\|r - H\tilde{s}\|^2$ is calculated for every combination of $s_1$, $s_2$, $s_3$, $s_4$. The complexity of ML decoding is immense, as $64^4 = 16.7$ million trials are needed for 64-QAM. Thus, this approach is often described as a "brute force" approach.

One aspect of the present invention is intended to provide a solution to this problem. This is achieved in one embodiment of the invention by taking advantage of the special form of the channel matrix and designing a reduced complexity ML detector.

In "Combined ML and DFE decoding for the V-BLAST system" (Won-Joon Choi; Negi, R.; Cioffi, J.M., *Communications, 2000. ICC 2000. 2000 IEEE International Conference on,* Vol.3, Iss., 2000, Pages:1243-1248 vol.3), an ML-DFE detector is presented, which is based on both ML decoding and the Successive Interference Cancellation technique. The channel matrix is partially decomposed, then the first symbols are ML decoded and the remaining symbols decoded successively using the DFE procedure.

In contrast, an embodiment of the present invention provides soft ST-detector output. Further, the technique used in that disclosure is targeted to space-multiplexing only and enhances the performance compared to the original V-BLAST algorithm. An embodiment of the present invention instead uses ST-codes with certain structure as described below and provides full-ML performance.

"On Detection Algorithms and Hardware Implementations for V-BLAST" (Z Guo and P Nilsson, in *Proceedings of the Swedish System-on-Chip Conference (SSoCC'02),* Falkenberg, Sweden, March 18-19, 2002) presents the p-ML detector, which is again based on both ML decoding and the Successive Interference Cancellation technique, similar to the paper by Choi et al discussed above.

"Successive decoding of multiple space time coded streams in multi-input multi-output systems" (Jung-Tao Liu, *Global Telecommunications Conference, 2002. GLOBECOM '02. IEEE,* Vol.1, Iss., 17-21 Nov. 2002, Pages: 1007-1011 vol.1) presents a method based on grouping the antennas into subsets which are individually ST-encoded. A DFE approach is used in order to estimate symbols belonging to all but one subset; this subset is then decoded and its contribution is subtracted from the signal vector. This process is repeated until all antenna groups are processed.

However, this technique uses a DFE approach not employed in embodiments of the present invention. This technique may suffer from propagation errors, which is inherent in a DFE approach.

"Optimum efficiently decodable layered space-time block codes" (Prasad, N.; Varanasi, M.K. Signals, *Systems and Computers, 2001. Conference Record of the Thirty-Fifth Asilomar Conference on,* Vol.I, Iss., 2001, Pages:227-231 vol.1) uses the technique of DFE combined with ST-codes (e.g. Alamouti), presented in the paper by Tarokh et al. referred to above.

"Applications of space-time block codes and interference suppression for high capacity and high data rate wireless systems" (Naguib, A.F.; Seshadri, N.; Calderbank, A.R., *Signals, Systems & Computers, 1998. Conference Record of the Thirty-Second Asilomar Conference on,* Vol.2, Iss., 1-4 Nov 1998, Pages:1803-1810 vol.2) describes the use of ML combined with interference cancellation schemes and ST-coding in order to suppress interference from co-channel space-time users. This paper is technically equivalent to the disclosure contained in International Patent Application WO9918682A3.

An embodiment of the invention presents an alternative to the popular sphere detectors. The specific embodiments of a detector presented herein are specifically operable to take account of certain ST-code structures and are low complexity and optimal performance (first embodiment) and near-optimal (embodiments 2 and 3).

One aspect of the invention provides a receiver operable to receive a multiple element signal resultant from a MIMO transmission, the receiver including decoding means for identifying symbols, from a predetermined set of such symbols, carried in said signal, and estimating the corresponding bits according to a pre-defined mapping of symbols to bits along with associated likelihood information representing the likelihood of an identified bit being such a bit, the decoding means being operable to detect bits in a received signal corresponding to an orthogonal transmission of information on two transmit antennas and taking account of the orthogonal transmission format, having already decoded in a first decoding stage the remaining data.

Specific embodiments of the invention will now be described, with reference to the accompanying drawings, in which:

Figure 1 illustrates a MIMO system of known construction;

Figure 2 illustrates a Space time coding arrangement for use in the MIMO system illustrated in figure 1;

Figure 3 illustrates a space time decoding tree traversed in a decoder of a receiver in the MIMO system illustrated in figure 1 employing the Space time coding arrangement illustrated in figure 2;

Figure 4 illustrates a space time decoding tree traversed in a decoder of a receiver in the MIMO system in accordance with a first embodiment of the invention;

Figure 5 illustrates a distance graph for the first embodiment of the invention;

Figure 6 illustrates a graphical representation of an encoding constellation used in conjunction with a second embodiment of the invention, identifying constellation members adjacent to a zero forcing estimate;

Figure 7 illustrates a graphical representation of a search process performed by a decoder in accordance with the second embodiment of the invention

Figure 8 illustrates a graphical representation of a further search process performed by a decoder in accordance with the second embodiment of the invention

Figure 9 illustrates a graphical representation of a yet further search process performed by a decoder in accordance with the second embodiment of the invention

Figure 10 illustrates a distance graph for the second embodiment of the invention;

Figure 11 illustrates a distance graph for a first stage of a third embodiment of the invention;

Figure 12 illustrates a distance graph for a second stage of the third embodiment of the invention;

Figure 13 illustrates a distance graph for a final result of the third embodiment of the invention;

Figure 14 illustrates a graph of performance characteristics of the first and second embodiments of the invention;

Figure 15 illustrates graph of performance characteristics demonstrating the effect of the number of candidates used in the process of the second embodiment on the performance of the second embodiment; and

Figure 16 illustrates a graph of performance characteristics of the third embodiment compared to the sphere max-log detector and the second embodiment with 10 candidates per layer.

The existence of a reduced complexity ML detector depends on the MIMO configuration and the design of the ST-code. Here it is assumed that the MIMO system uses 3 transmit and 3 receive antennas and the ST-code previously described. It should be noted that the principles behind the reduced complexity ML detector can also be applied to other MIMO configurations and ST-codes, however in the case of 3x3, the detector realization is particularly attractive as the full-ML performance can be achieved at significantly reduced complexity. All descriptions from now on will be focussed on this particular MIMO configuration and specific ST-code as previously described.

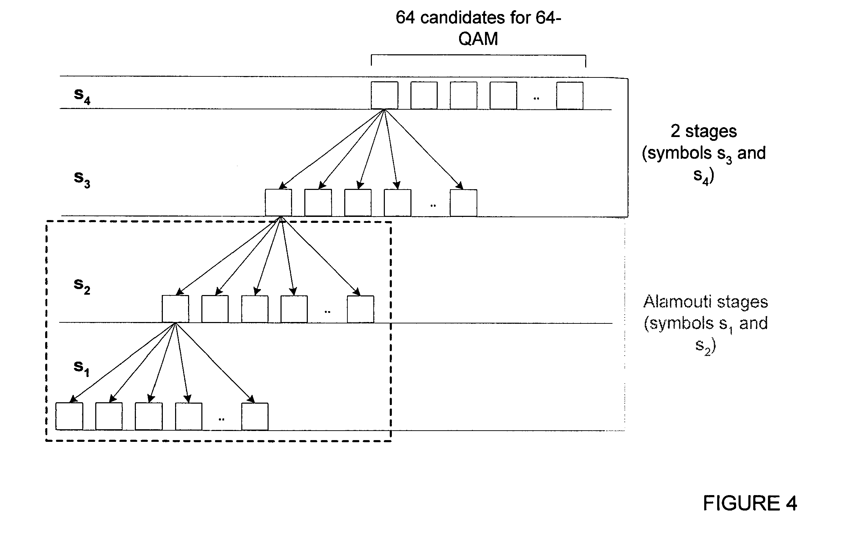

Figure 4 illustrates the manner of operation of the reduced complexity ML detector of this first specific embodiment of the invention. Operation of this embodiment harnesses the orthogonality of the sub-matrix of equation 3. This is possible by brute-force searching over all combinations of symbols $s_3$ and $s_4$, removing them from equation 3 with e.g. multiplication with the channel matrix coefficients and subtraction from the receive vectors. The remaining equations are then solved by simple linear processing. In this specific choice of ST-code, the Alamouti detector is used.

It is assumed that log-likelihood information is constantly updated during this exhaustive search process, according to equation 1.

The implementation searches over all possible combinations of $s_3$ and $s_4$. When picking a pair of $\{s_3, s_4\}$, equation 3 can then be simplified to:

$$
\begin{bmatrix}
r_{11} - h_{13}s_3 \\
r_{21} - h_{23}s_3 \\
r_{31} - h_{33}s_3 \\
r_{12}{}^* - h_{13}{}^* s_4 \\
r_{22}{}^* - h_{23}{}^* s_4 \\
r_{32}{}^* - h_{33}{}^* s_4
\end{bmatrix}
=
\begin{bmatrix}
h_{11} & h_{12} \\
h_{21} & h_{22} \\
h_{31} & h_{32} \\
h_{12}{}^* & -h_{11}{}^* \\
h_{22}{}^* & -h_{21}{}^* \\
h_{32}{}^* & -h_{31}{}^*
\end{bmatrix}
\begin{bmatrix}
s_1 \\
s_2
\end{bmatrix}
+
\begin{bmatrix}
n_{11} \\
n_{21} \\
n_{31} \\
n_{12}{}^* \\
n_{22}{}^* \\
n_{32}{}^*
\end{bmatrix}
$$

$$\Leftrightarrow$$

$$r' = h'\begin{bmatrix} s_1 \\ s_2 \end{bmatrix} + n$$

It will be appreciated that the new channel matrix $h'$ in this simplified expression of the system is orthogonal. This system of equations can be solved by simple linear processing (i.e. using an Alamouti detector):

$$r' = h' \begin{bmatrix} s_1 \\ s_2 \end{bmatrix} + n$$

$$\therefore h'^H r' = h'^H h' \begin{bmatrix} s_1 \\ s_2 \end{bmatrix} + h'^H n$$

$$\therefore h'^H r' = \gamma \cdot I_2 \cdot \begin{bmatrix} s_1 \\ s_2 \end{bmatrix} + h'^H n$$

$$\Rightarrow \begin{bmatrix} \hat{s}_1 \\ \hat{s}_2 \end{bmatrix} = h'^H r' / \gamma$$

yielding the ML estimates for the Alamouti-encoded symbols, where:

$$\gamma = |h_{11}|^2 + |h_{21}|^2 + |h_{31}|^2 + |h_{12}|^2 + |h_{22}|^2 + |h_{32}|^2 .$$

Finally, by quantizing $s_1$ and $s_2$ to the nearest constellation points, the distance metric $d_{s3s4} = \|r - H\tilde{s}\|^2$ can be calculated, where $\tilde{s} = [Q(s_1)\ Q(s_2)\ s_3\ s_4]^T$ and $Q(.)$ is the quantization function that maps a symbol to the nearest constellation point.

The vector $\tilde{s}$ that gives the minimum distance metric is therefore the hard-ML solution.

This procedure is equivalent to Maximum-Likelihood detection in terms of both performance and structure. As every possible combination of $s_3$ and $s_4$ is removed from equation 3, the Alamouti detector operates on the simplified equation; bearing in mind that the Alamouti detector is a ML detector, then it is evident that the complete detector is an ML detector, but with reduced complexity. The complexity is significantly reduced compared to a full-brute-force approach and is e.g. $64^2 = 4096$ trials for 64-QAM, while the full-ML approach, as noted above, would require $64^4 = 16.7$ million trials.

It should be noted that the orthogonality of the sub-matrix in equation 3 can only be exploited in this manner. A sphere detector would be unsuitable for carrying out the process of estimating $s_3$ and $s_4$; sphere decoding relies on reformulating the cost (distance) function into a summation over the individual transmit antenna symbol candidates, e.g. by QR decomposition of the channel matrix. There is no evident way of using this technique without destroying this specific property of orthogonality of the channel matrix that is used advantageously to simplify complexity.

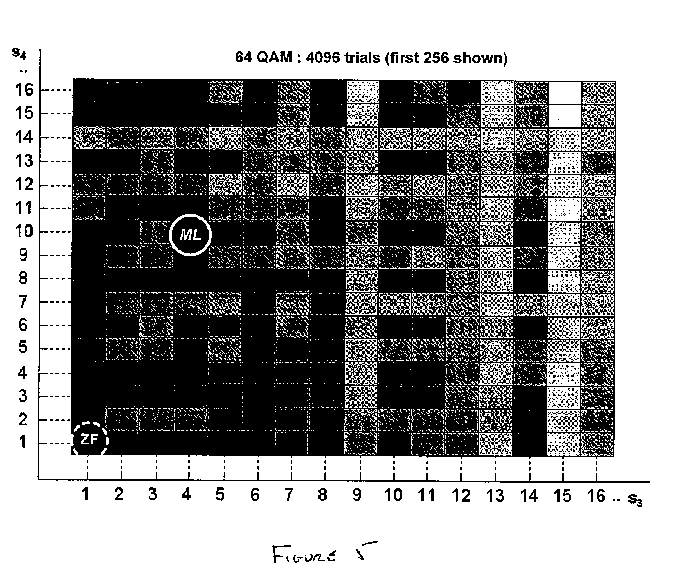

Figure 5 illustrates a distance graph for the first embodiment of the invention. This graph shows the calculated distance metrics $\|r - H\tilde{s}\|^2$ for every possible combination of $s_3$ and $s_4$. For reasons of clarity, whereas 4096 combinations of $s_3$ and $s_4$ are possible, only 256 are shown in Figure 5. The columns and rows are sorted according to the Euclidean distance of the candidate symbols from the solution produced by a zero forcing (ZF) receiver. Darker squares indicate lower distance metrics. The minimum distance metric is the ML solution. This decoder always finds the ML solution.

A second embodiment of the invention will now be described. This embodiment provides detection of symbols and associated likelihood information with a fixed degree of complexity. It is a list reduced-complexity ML-detector.

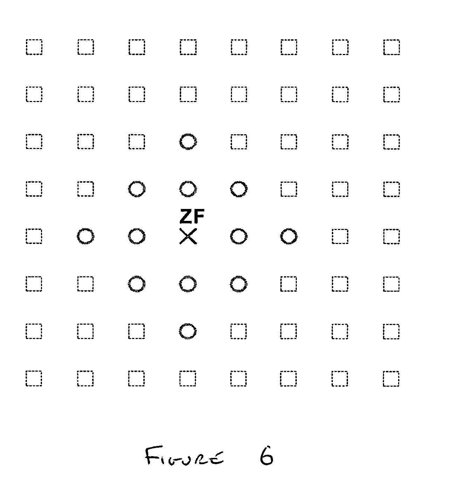

This detector operates on the basis that it is possible to deliver performance equal to or approaching that of the previous detector at a fraction of the complexity. The detector of the second embodiment of the invention has the same structure as the fundamental reduced-complexity detector, i.e. that described in the first specific embodiment of the invention, but instead of exhaustively searching over all 64 constellation points for symbols $s_3$ and $s_4$, it first calculates the ZF solution and then considers only the constellation points around this solution. Figure 6 gives an example of points considered around the ZF constellation point for one layer (e.g. $s_4$) of the search space.

The search is not exhaustive but delivers similar performance to the full-ML search given a sufficient number of candidates (the number of candidates depends on the SNR and is channel-specific. The problem of the number of candidates needed is not tackled by this embodiment of the invention. Certain embodiments not described here could calculate the number of candidates given some metrics on the channel "quality" and the Signal to Noise Ratio.

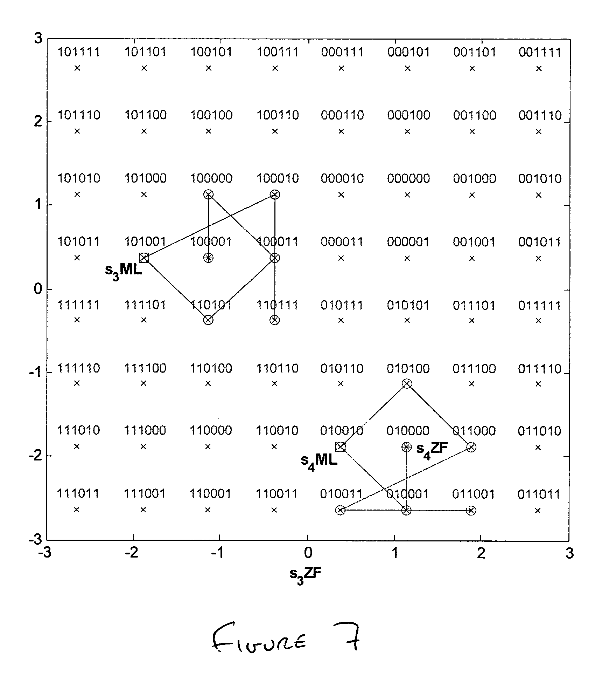

An example of a possible algorithm's path through the constellation space for layers $s_3$ and $s_4$ is shown in figure 7, which is a graphical representation of the algorithm's path through the constellation space. After an initial (ZF) estimation of the two symbols $s_3$ and $s_4$ is found, the detector samples the $s_3$ and $s_4$ space separately, trying out adjacent constellation points and evaluating the distance metric in every step (and of course updating the reliability information). The paths that the detector used in this particular example is:

$s_3 | s_4$: 100001 -> 100000 -> 100011 -> 110101 -> **101001** -> 100010 -> 110111 -> *terminate*
$s_4 | s_3$: 010000 -> 010001 -> **010010** -> 010100 -> 011000 -> 010011 -> O11001 -> *terminate*

The path for $s_3$ is traversed for each point in the $s_4$ path. In this case the ML solution for both layers is eventually reached (also shown in bold in the path list above). It should be noted that there is no guarantee that the detector of this embodiment will arrive at the ML solution, although in practice it is highly likely. In practice the average path length for each layer can be expected to be lower than this example: simulations for the 802.11n standard channel model 'B' showed that the ZF solution and the ML solution for at least one layer usually overlap for an SNR of around 15 dB per receive antenna and non-line-of-sight conditions. The algorithm's path length to reach the ML solution therefore depends on the channel under consideration. Nevertheless, the reader should be reminded that the hard-ML solution is not the only information that is supplied to the channel (e.g. Viterbi) decoder.

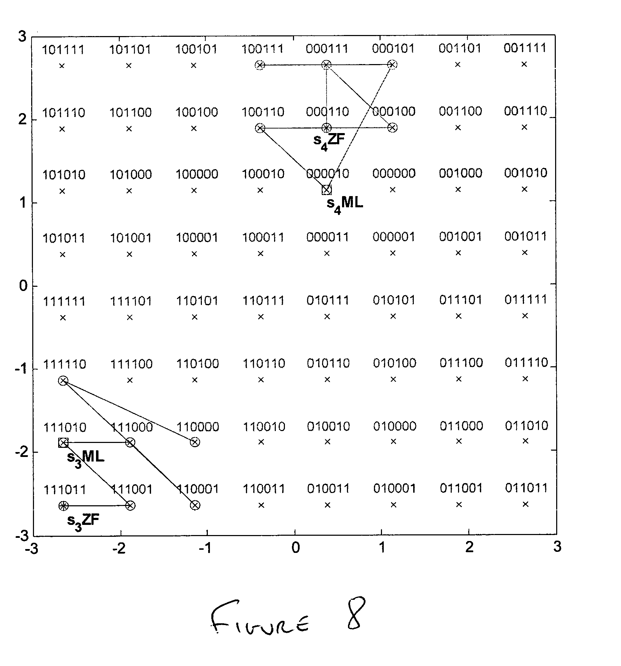

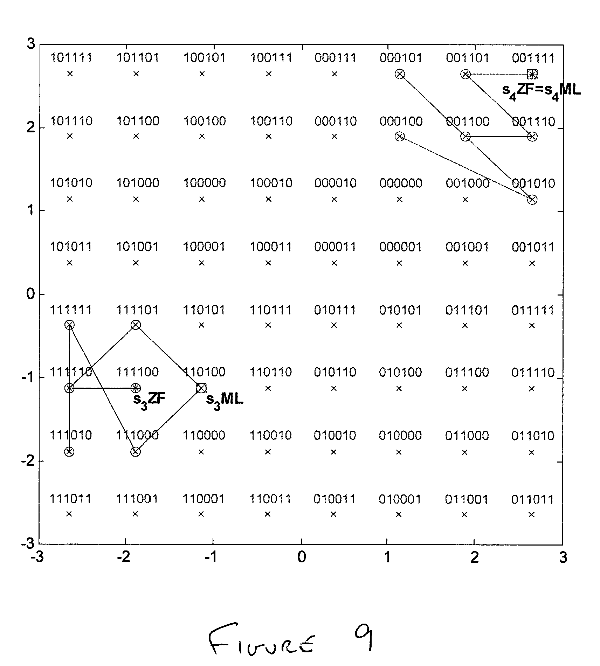

For the sake of clarity, other examples of the traversed path on both layers are found in figures 8 and 9.

In figure 8, the paths that the detector uses are:

$s_3 | s_4$: 111011 -> 111001 -> **111010** -> 111000 -> 110001 -> 111110 -> 110000 -> *terminate*
$s_4 | s_3$: 000110 -> 000111 -> 000100 -> 100110 -> **000010** -> 000101 -> 100111 -> *terminate*

In other words, the detector selects the first constellation point from the first path and evaluates all points across the second path. Then it selects the second point from the first path and evaluates all points across the second path. This process is repeated until all the points from the first path have been selected.

In figure 9, the paths are:

$s_3 | s_4$: 111100 -> 111110 -> 111101 -> **110100** -> 111000 -> 111111 -> 111010-> *terminate*

$s_4 | s_3$: **001111** -> 001101 -> 001110 -> 001100 -> 000101 -> 001010 -> 000100 -> *terminate*

In this example, the ML solution for symbol $s_4$ coincided with the ZF solution. The detector would still need to evaluate all combinations to reach that conclusion in this embodiment.

It will be appreciated that the detector of this embodiment offers one example of several variants all operable in accordance with the same overall concept.

For example, it is possible to design a metric that could be used for stopping the search, e.g. when the calculated distance metrics $\|r - H\widetilde{s}\|^2$ in the search begin to surpass a large value.

In cases where the noise is correlated across layers $s_4$ and $s_3$, it would be possible to order the candidates according to the predicted noise vector. For example, by observing the distance metrics $\|r - H\widetilde{s}\|^2$ across the search space of $s_4$, it would be possible to have an estimation of the properties of the noise vector for this layer (e.g. vector direction). Knowing that the noise vector for layer $s_3$ is correlated with the noise vector for $s_4$, it would be possible to estimate the noise vector direction for layer $s_3$ and therefore prioritize the constellation points in that direction.

It should also be noted that the order in which the detector considers the constellation points is not significant, as long as the detector considers the constellation points that have the smallest Euclidean distance to the ZF solution point.

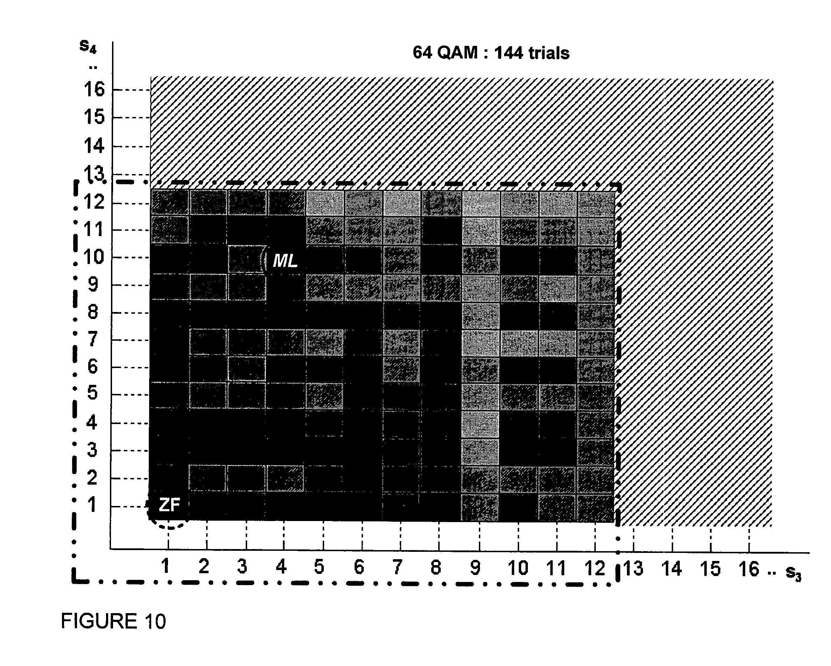

Figure 10 illustrates a distance graph for the second embodiment of the invention. As for the first embodiment, the graph is sorted. Only the first 12 candidates from each layer are considered.

The complexity is lower than that of the first embodiment: and is in the order of (num_candidates)$^2$, while the performance is in the region of ML for more than 12 candidates.

In this second embodiment, the initial solution can be based on solving for the ZF solution, using for example V-BLAST or more preferably a decomposition-based approach (QR-decomposition, sorted-QR decomposition, CORDIC). An interesting property of the specific space-time code used throughout these examples is that the ordering to be performed during decomposition is known; this is because of the properties of the columns of the channel matrix : columns 1 and 2 have the same magnitude - the same holds for columns 3 and 4. The magnitude of column 1 or 2 is statistically (on average) more significant the magnitude of column 3 or 4, because half of the elements of columns 3 and 4 are zero.

It is possible that a hardware processor capable of parallelization would jointly consider two or more candidates (belonging to the same layer). It is evident that processing can be simplified in this way because repeating the whole process for any two adjacent e.g. $s_4$ candidates involves repeated steps (e.g. removing $s_3$ from the equation) or common arithmetic operations (the multiplications of a with b, then with b+d, then with b+2*d etc. can be reduced to a single multiplication plus some multiplications with 2 and additions). However, without loss of generality and for ease of description, only the case of serial candidate consideration without explicit optimizations will be assumed throughout this invention.

An improved heuristic-method can be applied in a third embodiment of the invention which provides a fixed complexity method of detecting symbols, and determining associated likelihood information, in a stream received on a MIMO channel.

In accordance with this third specific embodiment, a novel heuristic algorithm will now be described, which has equivalent performance but further reduction in complexity as compared with the ML and candidate-ML algorithms described with regard to the first and second specific embodiments above.

With regard to figure 5, illustrating the distance graph for the arrangement of the first specific embodiment, point (1,1) is the ZF solution. The distance graph is sorted in both layers $s_3$ and $s_4$ according to the Euclidean distance of each symbol from its own initial estimation (ZF). It can be observed that there is a certain periodicity on both dimensions to the regional minimum values on this chart. This periodicity indicates the direction towards the ML solution, in other words that we are converging towards the ML solution whenever the vector direction/angle is approximating the ML solution vector direction/angle. However convergence is not guaranteed because the distance map presents local minima in both directions. This is because the convergence depends on the condition of the channel matrix.

The underlying concept harnessed in the third embodiment described here is to combine local minima across both dimensions/layers in order to get the global minimum. This essentially yields a sub-optimal decoder but however yields a performance in the region of the ML decoder with far fewer distance metric calculations (in particular, fewer than calculated in the second embodiment for the same performance).

The algorithm operates in two stages, having parameters $a$ and $b$ where $a$ is the number of candidates and $b$ is the secondary number of candidates. An initial solution such as the ZF solution $\tilde{s}ZF = [s_1ZF\ s_2ZF\ s_3ZF\ s_4ZF]^T$ is needed.

The steps of the algorithm can be described as follows:

> *First stage.* Perform $2*a$ searches:
>
> > Keep $s_3$ fixed to the initial (ZF) solution and search over a certain number of candidates for $s_4$ centred around the $s_4ZF$ solution. Select the best b candidates: $\{x_1,x_2,..,x_b\}$ that yield the minimum distances.
> > Keep $s_4$ fixed to the initial (ZF) solution and search over a certain number of candidates for $s_3$ centred around the $s_3ZF$ solution. Select the best b candidates: $\{y_1,y_2,..,y_b\}$ that yield the minimum distances.
> > *Second stage.* Search over the $b^2$ space
> > Exhaustively search over the b*b matrix $[\{y_1,y_2,..,y_b\}.\{x_1,x_2,..,x_b\}]$

Total: $2*a$ -1 + $b*b$ calculations instead of *num_candidates²*.

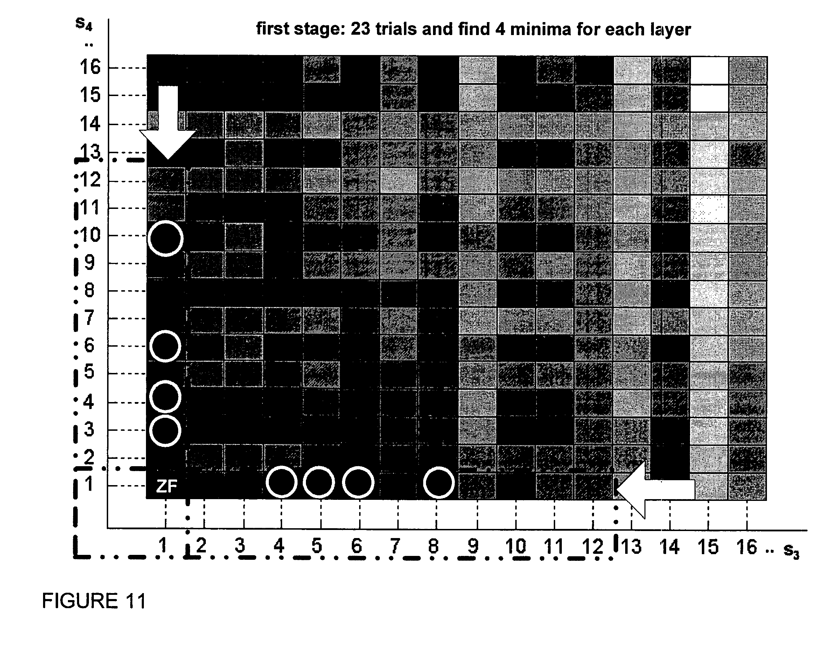

A working example of the process of the third embodiment will now be described with reference to figures 11 to 13.

As illustrated in figure 11, only 23 distance metrics $\|r - H\tilde{s}\|^2$ are calculated in a first stage of the process of the third embodiment, and the 4 minima from each layer are found.

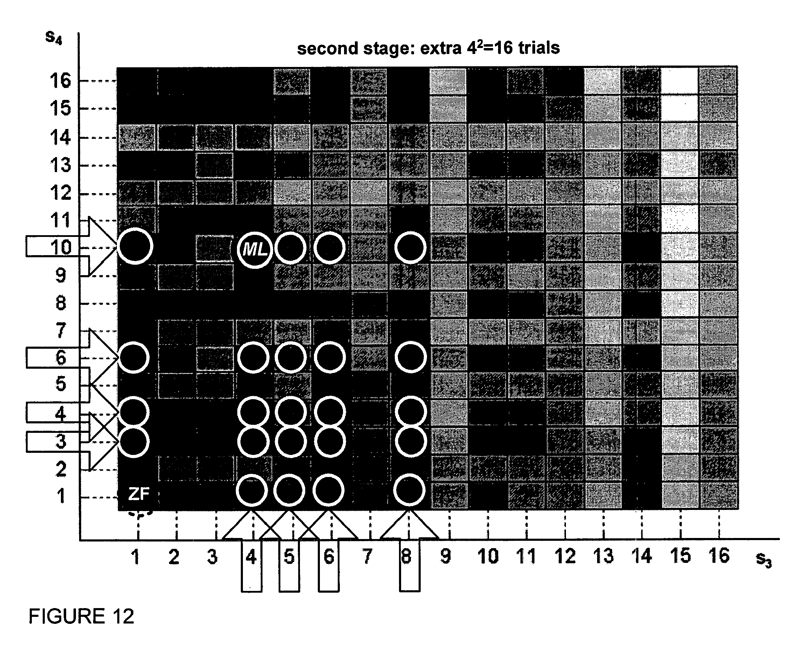

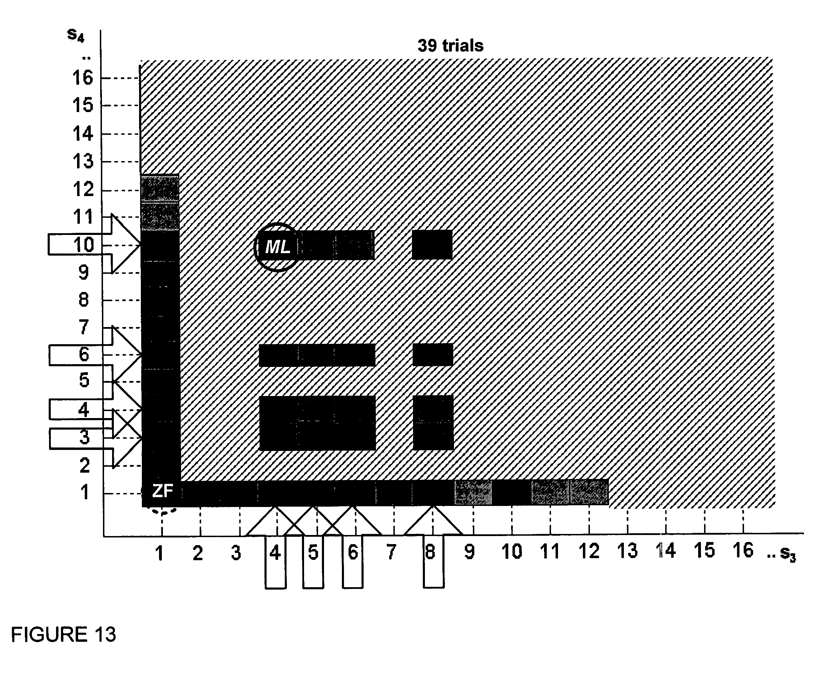

In a second stage of the third embodiment, as illustrated in figure 12, the 4 minima from each layer are used as pointers (indicated by the arrows) to form a 4*4 matrix, then another 16 distance metrics $\|r - H\tilde{s}\|^2$ corresponding with this matrix are calculated. The ML solution was found in this particular example, although it is not guaranteed in general. Thus, as illustrated in figure 13, 39 trials (23 in the first stage and 16 in the second stage) are performed in total and thus 39 candidates for the ML are identified.

A generalized version of the third embodiment is also envisaged. This involves modifying the algorithm so that it is more general. The number of candidates for layer $s_3$ might not be the same as layer $s_4$. The steps of the generalized algorithm would then be:

> *First stage.* Perform $a_{s3}+a_{s4}$ searches:
>
> > Keep $s_3$ fixed to the initial (ZF) solution and search over $a_{s4}$ candidates for $s_4$ centred around the $s_4ZF$ solution. Select the best $b_{s4}$ candidates: $\{x_1,x_2,..,x_{b\_s4}\}$ that yield the minimum distances.
> > Keep $s_4$ fixed to the initial (ZF) solution and search over $a_{s3}$ candidates for $s_3$ centred around the $s_3ZF$ solution. Select the best $b_{s3}$ candidates: $\{y_1,y_2,..,y_{b\_s3}\}$ that yield the minimum distances.
>
> *Second stage.* Search over the $b_{s3}*b_{s4}$ space
> Exhaustively search over the $b_{s3}*b_{s4}$ matrix $[\{y_1,y_2,..,y_{b\_s3}\}.*\{x_1,x_2,..,x_{b\_s4}\}]$

Total: $a_{s3}+a_{s4}$ -1 + $b_{s3}*b_{s4}$ calculations instead of *num_candidates²*.

In a further modification of the third embodiment, it would also possible to keep the number of candidates fixed by having $a_{s3}=a_{s4}$. and $b_{s3}$ and $b_{s4}$ only satisfy $b_{s3}+b_{s4}=b$. The best candidates from both layers considered together

$\{x_1, x_2, ..., x_{b\_s4}, y_1, y_2, .., y_{b\_s3}\}$ would then be chosen. This might result in choosing, for example, only $x_1$ from layer $s_4$ and $\{y_1, y_2, y_3\}$ from layer $s_3$ as they yield the minimum distances over both layers. The number of calculations of the second stage is therefore variable, with $(b/2)^2$ as an upper and $1*b=b$ as a lower bound. This specific modification is also benchmarked in the examples section.

It is also possible that a minimum number of candidates (i.e. rows and columns in the distance graph) are considered by the detector.

This technology enables optimum performance (hard- and soft-output ML-detection) of MIMO ST-coded streams under significantly reduced complexity.

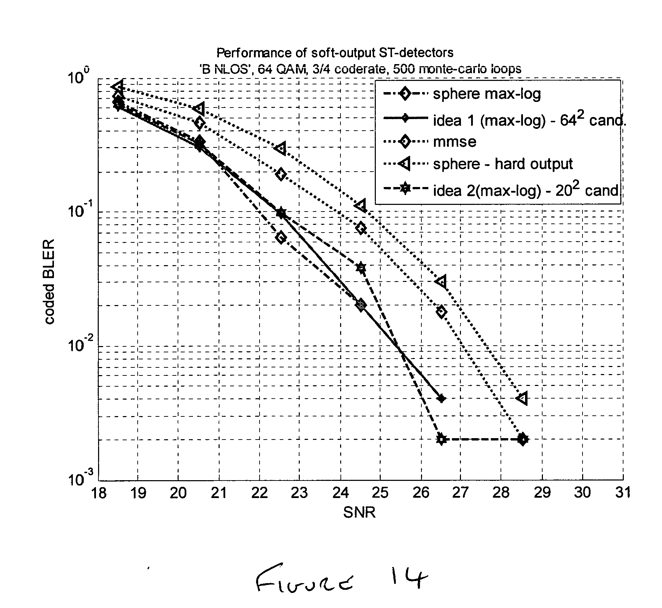

Simulations have shown that only considering a certain number of candidates yields practically identical performance as the exhaustive approach, for both hard- and soft-output detectors. Figures 14 to 16 illustrate the performance characteristics of the various described embodiments in practical examples.

Figure 14 illustrates performance of the first and second embodiments (labelled 'idea 1' and 'idea 2' respectively). The first embodiment (as well as embodiment 2 with 20 candidates across each layer) yield optimum performance (compared with sphere decoder max-log in the figure). MMSE is a soft output detector.

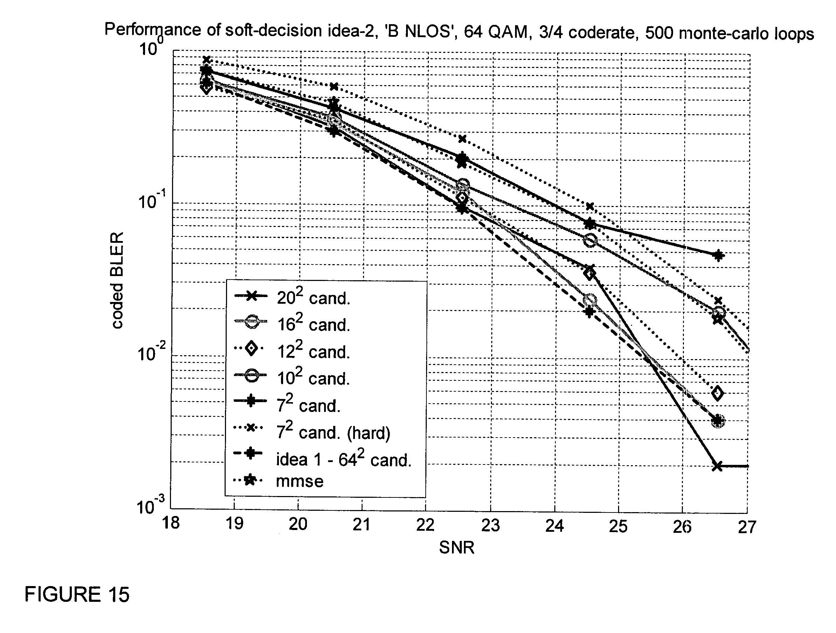

Figure 15 illustrates the effect of the number of candidates on the performance of the second embodiment. It can be seen that 7 candidates yield the same performance as the MMSE detector, while more than 12 candidates approach the optimum solution (the first embodiment / ML).

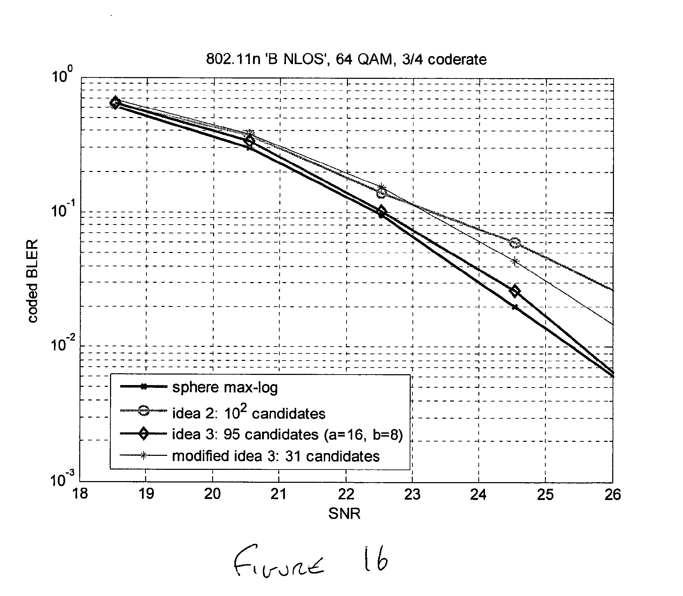

Figure 16 illustrates performance of the third embodiment compared to the sphere max-log detector and the second embodiment with 10 candidates per layer. The line labelled "Modified idea 3" corresponds with the modified version of the third embodiment as described at the end of that embodiment's description above.

During the operation of the decoders presented in the second embodiment (and also in the third embodiment), it can arise that the values $\min\limits_{s|b_k=-1} \dfrac{\|r - H\widetilde{s}\|^2}{N_0}$ and $\min\limits_{s|b_k=+1} \dfrac{\|r - H\widetilde{s}\|^2}{N_0}$ for a certain bit $b_k$ are empty. This happens because not all possible values for $\widetilde{s}$ are evaluated. As an example, in the first embodiment, $s_4$ and $s_3$ are exhaustively evaluated, so the both of the values above exist. However, the linear detector of the next stage delivers only a single value for $s_2$ and $s_1$ for a given $s_4$ and $s_3$. Therefore it might occur that e.g. bit $b_k = +1$ belonging to either $s_1$ or $s_2$ never occurs for a certain k so the value $\min\limits_{s|b_k=+1} \dfrac{\|r - H\widetilde{s}\|^2}{N_0}$ will be empty. One way to rectify this problem would be to initialize all the values for $\min\limits_{s|b_k=-1} \dfrac{\|r - H\widetilde{s}\|^2}{N_0}$ and $\min\limits_{s|b_k=+1} \dfrac{\|r - H\widetilde{s}\|^2}{N_0}$ a certain initial value, preferably one that is larger than the Euclidean distance of the two constellation points spaced the furthest apart on the constellation grid.

While the foregoing is provided by way of example of the invention for which protection is claimed, it will be appreciated that further modifications and alternative arrangements will fall within the scope of protection, which is to be determined by the appended claims as construed in the light of the description and the drawings.

In particular, it will be appreciated that the invention can be put into practice in suitably configured general purpose computing and/or communications apparatus, such as configured by software, which may be introduced by means of a storage medium readable by the apparatus concerned, or by apparatus networked with the apparatus concerned, or by apparatus with which the apparatus concerned is temporarily at least in communication, whether directly or indirectly. Further, the software could be introduced by means of a program downloaded from a remotely accessible data server, such as via the internet. Alternatively, the apparatus may be configured to operate in accordance with an aspect of the invention by virtue of introduction thereto of suitable hardware components, such as an application specific integrated circuit or similarly configured electronic means to configure the apparatus accordingly.

**Claims**

1. A method of detecting symbols, each being a member of a predetermined set of symbols, in a signal received from a MIMO communications channel, said signal comprising signal components resultant from transmission of a plurality of symbols on at least two antennas in an orthogonal arrangement, and a signal component resultant from the transmission of at least one further symbol on at least one further antenna, the method **characterised by**:

firstly determining the identity of said at least one further symbol by reviewing a set of possible values of said symbol and selecting the most likely candidate symbol; and

secondly determining the identity of said plurality of symbols by taking account of the orthogonal arrangement of the transmission of the plurality of symbols.

2. A method according to claim 1 wherein the first determining step comprises exhaustively determining the identity of said at least one further symbol by reviewing the set of values of said symbol and selecting the most likely candidate symbol;

3. A method according to claim 2 wherein the plurality of symbols conform to a Space Time encoding structure, and said second determining step comprises taking account of the Space Time encoding structure in determining said at least one further of the symbols.

4. A method according to claim 2 or claim 3 wherein the received signal is received on the basis of transmission of four symbols encoded together, the exhaustive determining step comprising determining the value of two of the symbols by firstly determining the value of a first one of said symbols by reviewing all possible values of said symbol and selecting the most likely candidate symbol and secondly determining the value of a second one of the symbols by reviewing all possible values of said symbol and selecting the most likely candidate symbol.

5. A method according to claim 4 wherein the further determining step comprises determining a set of candidate symbols selected from the total set of possible symbols, said candidate symbols being selected on the basis of the result of the exhaustive determining step, determining a subset of the most likely candidates from this candidate set on the basis of the orthogonal arrangement, and determining likelihoods of combinations of said symbols being received, on the basis of said subset of candidate symbols.

6. A method according to claim 5 wherein the orthogonal arrangement of symbols is an Alamouti arrangement.

7. A method according to claim 1 wherein the first determining step comprises selecting an initial estimate of a symbol to be detected, wherein the set of potential symbols can be expressed as at least a two dimensional set, and wherein said set of possible values comprises a set of neighbours in said two dimensional set, of said initial estimate.

8. A method according to claim 7 wherein the initial estimate is a zero forcing estimate.

9. A method according to claim 7 or claim 8 wherein the first determining step comprises determining the identity of two symbols, and wherein for each potential value of one of said two symbols, the likelihood of the other of said two symbols is determined across the set of potential values, such that the identities of the two symbols are determined on the basis of the most likely combination of the two, around the initial estimate of each.

10. A method according to claim 1 wherein the first determining step comprises determining identities of two received symbols, the two symbols being identified on the basis of a set of possible candidates, the candidates being identified on the basis of a determination of proximity from a zero forcing estimate, the nearest combinations of the two symbols to the zero forcing estimate being selected for further consideration as to the most likely combination to correspond to the identity of the two symbols.

11. A method according to claim 10 wherein the step of determining the set of possible candidates includes determining a first set of candidates according to proximity to an initial estimate, determining distance metric information for a subset of said first set and detecting a periodicity in the distance metric information of this subset, determining an orientation of the maximum likelihood solution on the basis of this detected periodicity and determining a set of candidates most likely to produce the maximum likelihood solution, according to the orientation of the maximum likelihood solution and said candidates' proximity to the initial estimate.

12. A method according to claim 11 wherein the initial estimate is a zero forcing estimate.

13. A receiver for use in a MIMO communications system, comprising a detector for detecting symbols, each being a member of a predetermined set of symbols, in a signal received from a MIMO communications channel, said signal comprising signal components resultant from transmission of a plurality of symbols on at least two antennas in an orthogonal arrangement, and a signal component resultant from the transmission of at least one further symbol on at least one further antenna, the detector in turn **characterised by**:

a first symbol determining stage operable to search across a set of possible symbols for the most likely candidate symbol; and

a second symbol determining stage operable to determine the identity of said plurality of symbols by taking account of the orthogonal arrangement of the transmission of the plurality of symbols.

14. A receiver according to claim 13 wherein the first symbol determining stage is operable to search exhaustively across all potential candidate symbols.

15. A receiver according to claim 13 or claim 14 wherein the plurality of symbols conform to a Space Time encoding structure, and said second symbol determining stage comprises means operable to take account of the Space Time encoding structure in determining said further symbols.

16. A receiver according to claim 13 or claim 14 wherein the first symbol determining stage is operable to determine two symbols.

17. A receiver according to claim 16 wherein the orthogonal arrangement of symbols is an Alamouti arrangement, and the second symbol determining stage is an Alamouti compatible detector.

18. A receiver according to claim 13 wherein the first symbol determining stage is operable to select an initial estimate of a symbol to be detected, wherein the set of potential symbols can be expressed as at least a two dimensional set, and wherein said set of possible values comprises a set of neighbours in said two dimensional set, of said initial estimate.

19. A receiver according to claim 18 wherein the initial estimate is a zero forcing estimate.

20. A receiver according to claim 18 or claim 19 wherein the first symbol determining stage is operable to determine the identity of two symbols, and wherein for each potential value of one of said two symbols, the first symbol determining stage is operable to determine the likelihood of the other of said two symbols across the set of potential values, such that the identities of the two symbols are determined on the basis of the most likely combination of the two, around the initial estimate of each.

21. A receiver according to claim 13 wherein the first symbol determining stage is operable to determine the identities of two received symbols, the two symbols being identified on the basis of a set of possible candidates, the candidates being identified on the basis of a determination of proximity from a zero forcing estimate, the nearest combinations of the two symbols to the zero forcing estimate being selected for further consideration as to the most likely combination to correspond to the identity of the two symbols.

22. A receiver according to claim 21 wherein the first symbol determining stage comprises means for determining a set of possible candidates operable to determining a first set of candidates according to proximity to an initial estimate, to determine distance metric information for a subset of said first set and to detect a periodicity in the distance metric information of this subset, to determine an orientation of the maximum likelihood solution on the basis of this detected periodicity and to determine a set of candidates most likely to produce the maximum likelihood solution, according to the orientation of the maximum likelihood solution and said candidates' proximity to the initial estimate.

23. A receiver according to claim 22 wherein the initial estimate is a zero forcing estimate.

24. A system comprising a receiver according to any of claims 13 to 23.

25. A method of communicating information comprising transmitting information on a MIMO channel and receiving the information including detecting information in accordance with any of claims 1 to 12.

26. A computer program product comprising computer executable instructions to configure a computer to operate as a receiver in accordance with any of claims 13 to 23.

27. A computer program product comprising computer executable instructions to configure a computer to detect symbols on a received signal in accordance with any of claims 1 to 12.

FIGURE 1

FIGURE 3

FIGURE 2

FIGURE 4

64 QAM : 4096 trials (first 256 shown)

FIGURE 5

FIGURE 6

FIGURE 7

FIGURE 8

FIGURE 9

FIGURE 10

FIGURE 11

FIGURE 12

FIGURE 13

Performance of soft-output ST-detectors
'B NLOS', 64 QAM, 3/4 coderate, 500 monte-carlo loops

Legend:
- ⋯◇⋯ sphere max-log
- idea 1 (max-log) - $64^2$ cand.
- ⋯◇⋯ mmse
- ⋯◁⋯ sphere - hard output
- idea 2(max-log) - $20^2$ cand

Axes: coded BLER vs SNR

FIGURE 14

Performance of soft-decision idea-2, 'B NLOS', 64 QAM, 3/4 coderate, 500 monte-carlo loops

Legend:
- $20^2$ cand.
- $16^2$ cand.
- $12^2$ cand.
- $10^2$ cand.
- $7^2$ cand.
- $7^2$ cand. (hard)
- idea 1 - $64^2$ cand.
- mmse

y-axis: coded BLER
x-axis: SNR

FIGURE 15

EP 1 635 500 A1

802.11n 'B NLOS', 64 QAM, 3/4 coderate

Legend:
- sphere max-log
- idea 2: $10^2$ candidates
- idea 3: 95 candidates (a=16, b=8)
- modified idea 3: 31 candidates

X-axis: SNR
Y-axis: coded BLER

FIGURE 16

**European Patent Office**

## EUROPEAN SEARCH REPORT

Application Number

EP 05 25 4161

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | BADIC B ET AL: "Extended Alamouti codes in correlated channels using partial feedback" COMMUNICATIONS, 2004 IEEE INTERNATIONAL CONFERENCE ON PARIS, FRANCE 20-24 JUNE 2004, PISCATAWAY, NJ, USA,IEEE, 20 June 2004 (2004-06-20), pages 896-900, XP010710066 ISBN: 0-7803-8533-0 * the whole document * ----- | 1-27 | H04L1/06 |
| A | UYSAL M ET AL: "NEW SPACE-TIME BLOCK CODES FOR HIGH THROUGHPUT EFFICIENCY" GLOBECOM'01. 2001 IEEE GLOBAL TELECOMMUNICATIONS CONFERENCE. SAN ANTONIO, TX, NOV. 25 - 29, 2001, IEEE GLOBAL TELECOMMUNICATIONS CONFERENCE, NEW YORK, NY : IEEE, US, vol. VOL. 2 OF 6, 25 November 2001 (2001-11-25), pages 1103-1107, XP001099276 ISBN: 0-7803-7206-9 * the whole document * ----- | 1-27 | |

**TECHNICAL FIELDS SEARCHED (IPC)**

H04L

The present search report has been drawn up for all claims

| Place of search | Date of completion of the search | Examiner |
|---|---|---|
| The Hague | 13 January 2006 | Toumpoulidis, T |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)